(19) Europäisches Patentamt / European Patent Office / Office européen des brevets

(11) **EP 3 394 625 B1**

(12) **EUROPEAN PATENT SPECIFICATION**

(45) Date of publication and mention
of the grant of the patent:
**27.05.2026 Bulletin 2026/22**

(21) Application number: **16825748.3**

(22) Date of filing: **22.12.2016**

(51) International Patent Classification (IPC):
***G01R 31/36*** *(2020.01)*

(52) Cooperative Patent Classification (CPC):
**G01R 31/389; G01R 31/396;** Y02E 60/10

(86) International application number:
**PCT/EP2016/082340**

(87) International publication number:
**WO 2017/109049 (29.06.2017 Gazette 2017/26)**

(54) **DEVICE FOR MEASURING CHARACTERISTICS OF HIGH VOLTAGE BATTERIES**

VORRICHTUNG ZUR MESSUNG DER EIGENSCHAFTEN VON HOCHSPANNUNGSBATTERIEN

DISPOSITIF POUR MESURER DES CARACTÉRISTIQUES DE BATTERIES HAUTE TENSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.12.2015 EP 15202147**

(43) Date of publication of application:
**31.10.2018 Bulletin 2018/44**

(73) Proprietor: **VITO NV
2400 Mol (BE)**

(72) Inventors:
 • **DE BREUCKER, Sven
  2400 Mol (BE)**
 • **WEYEN, Dominique
  2400 Mol (BE)**
 • **COENEN, Peter
  2400 Mol (BE)**

(74) Representative: **Oryon NV
Tavernierkaai 2
2000 Antwerp (BE)**

(56) References cited:
 DE-A1- 102013 218 081   DE-A1- 102014 207 481
 US-B1- 6 765 388

## Description

The present invention relates to systems, methods and component parts for measuring a characteristic of batteries or other energy storage devices. In particular, the present invention relates to systems, methods and component parts for measuring a characteristic of high voltage batteries, e.g. 0.1 to 1 kV and/or automotive batteries as used in electric or hybrid automobiles. In particular, the present invention relates to systems, methods and component parts for performing a battery diagnostic test, for example on high voltage batteries, e.g. 0.1 to 1 kV and/or automotive batteries as used in electric or hybrid automobiles. One such characteristic or diagnostic parameter is the impedance of such batteries and one such method is impedance spectroscopy testing. Preferably, the present invention relates to a portable or handheld device for measuring a characteristic of batteries or other energy storage devices.

## Background

Measuring the battery impedance through a battery impedance spectroscopy test is a known way to establish the impedance of the battery at different frequencies. In order to measure the impedance of the battery at a specific frequency, a current at that specific frequency needs to be injected into the battery by a power-electronic set-up or some other form of generator. The battery impedance measurement device monitors both the injected current and the resulting voltage response and determines the real and imaginary part of the impedance for the injected frequency. The resulting impedance characteristic (together with other measurements) is an indicator for amongst others, the state-of-charge (SoC) and state-of-health (SoH) of the battery. As batteries have a significant capacitance, injecting AC current into such batteries requires considerable amounts of power.

## Low voltage handheld battery testers

Most handheld battery testers are designed for 12V lead-acid batteries which are used in automotive applications, in emergency power supplies (UPS), in residential solar storage devices, etc. Construction of a handheld device for these batteries is feasible because the low voltage and limited currents allow the construction of a device which is capable of producing the required currents as well as measuring these currents and the voltage response in a relatively compact device. In order to deliver the necessary energy during the positive half of the sinusoid and store this energy during the negative half of the sinusoid, the device can be equipped with a fairly large battery (7 Ah/4.8 V for [1] - reference are at the end of the text) to cover the energy requirements of the injected currents. The low voltage also allows balancing of the battery voltage with a small capacitor and limiting the current with a small resistor or inductor [1][2][3]. Other handheld devices are only capable of measuring the voltage and resistance up to 40 V [4], while some battery analyzers go up to 600 $V_{dc}$ and can measure ac-ripple currents up to 6 V [5]. Although the latter devices are able to measure the voltage response and the impedance of the battery under test when a certain current is injected into the battery system, they are unable to provide the required current injection for large batteries such as automotive batteries.

## Drawbacks of high voltage battery testers

At higher voltages, these impedance measurement devices rely on an external bidirectional power supply, mostly a power-electronic set-up, to inject the required current into the battery under test. These power supplies have some drawbacks:

- The specific power of the power supply is low, e.g. a conventional commercial application has a specific power of only 220 W/kg [6], which results in a heavy and bulky test equipment. In order to inject a 10 A current in a 600 V battery, this would require a 27 kg converter.
- The power supply requires a bidirectional grid-connection, thus limiting the application to stationary test benches.
- Due to the large size and weight of the power supply the batteries have to be shipped to the test facility rather than batteries being tested at local garages or on a road when the automobile has broken down and that might have been caused by the loss of performance of the battery.

If a portable system is to take over the role of the bidirectional power supply, an energy storage system would have to be assembled which is capable of delivering the required energy and power for the impedance spectroscopy test.

The most demanding application of the impedance spectroscopy measurement is the injection of a low frequency current as the storage system first needs to store the energy delivered by the battery, followed by the delivery of the same amount of energy from the storage system to the battery. At higher frequencies less storage is required as the energy comprised within one half cycle decreases.

Take the example of a 0.1 Hz current injection with an amplitude of 10 A into a 600 V battery. We assume a triangular-shaped current injection as this is the common shape of the injected converter current due to the inductor of the dc-dc converter, but this is just an example for ease of calculation. The actual waveform can be a sinusoid, a square or triangle wave, a sawtooth, or a DC-pulse, etc. The peak power that needs to be delivered is 6 kW. The energy comprised in half a cycle of the triangle is 30 kJ or 8,3 Wh.

An electrolytic capacitor is not a viable option as even a large (90*145 mm/1.4 kg) 4.7 mF 400 V capacitor is only able to store some 380 J, which would require 80 such capacitors to cover one half cycle of the charge/discharge cycle, resulting in a storage pack of some 110 kg.

If supercapacitors were used to cover the required energy, some 240 small 50 F capacitors would be needed in series a pack between 300 and 600 V is used. However, the resulting supercapacitor storage pack would weigh some 6 kg and have a volume of 5 liter. This is too heavy and bulky for a handheld device. This excludes the use of supercapacitors as well. The constraint for both electrolytic capacitors and supercapacitors is the amount of energy that can be stored.

A handheld device becomes rather impractical, based on a maximum mass of 3 kg for a portable device, when the minimum frequency is at around 1 Hz. Below this frequency the device becomes too heavy due to the energy requirement of the supercapacitors.

If batteries are used, the stored energy is no longer the limiting factor, but the amount of power that can be delivered is. As an example, one could take a Panasonic NCR18650B battery, but increase the maximum charge and discharge current from the actual 0.5C to 3C in this example, such that a single cell can deliver the required 10 A current for the impedance spectroscopy. In order to deliver and store the required 6 kW, a series string of 166 cells is required. The storage pack would weigh over 8 kg and have a volume of some 6 liter. For batteries the limiting factor is the power, hence, the mass remains at 8kg at all frequencies, resulting in at least 9 kg (including the converter) for the device at all frequencies. Obviously, this third option is also not a viable option for a handheld device.

If we want to build the hand-held device with the three mentioned storage devices, the weight of the power electronics, used to exchange energy between the battery under test and the storage, has to be added to the weight of the storage. Assume a 6 kW dc-dc converter between the energy storage device and the battery under test having a mass of 1 kg [9]. The battery storage only requires one such converter as the battery voltage is relatively constant for a 10 s cycle. The electrolytic capacitor and supercapacitor storage both need two of these converters as the voltage of the capacitors decreases drastically during discharge and needs to be boosted by a separate converter.

The total mass of the solution thus becomes:

- 

$$\text{Electrolytic capacitor (110 kg)} + 2 * 6\text{ kW dc-dc converter (2 * 1 kg)} = 112\text{ kg}$$

- 

$$\text{Supercapacitor (6 kg)} + 2 * 6\text{ kW dc-dc converter (2 * 1 kg)} = 8\text{ kg}$$

- 

$$\text{Battery (8 kg)} + 1 * 6\text{ kW dc-dc converter (1 kg)} = 9\text{ kg}$$

The lightest solution for the battery tester thus would weigh some 8-9 kg, not taking the encasing, measurement devices, controller etc. into account.

There is likely to be an increase of electric and hybrid automobiles, for example, it has been estimated that 20 years from now there may be a million or several million used battery packs from electric cars. Some of these batteries can be repaired, e.g. by replacing defective modules and putting them back into stock as remanufactured parts or some can be made available for secondary uses.

It has been estimated that a large percentage of the used automotive batteries could be suitable for post-vehicle use, while some would be so damaged as being beyond repair. Battery materials can be expensive. For example, cobalt in NCM batteries is expensive, hence, the interest to recycle these batteries. However, the materials in a lithium-ion battery pack are said to be relatively inexpensive, and, hence, there would perhaps be an interest in either finding a new use or disposing of the batteries permanently. To avoid unnecessary waste it would be necessary to make an accurate assessment of the remaining performance of each battery in a speedy and economical way.

One potential post-vehicle application is combining a used electric-car battery with photovoltaic solar panels for home use, allowing homeowners not only to generate renewable electricity but to store it. Electric utilities are said to be considering the opportunities to decouple such homes from the grid temporarily during periods of peak demand, reducing the utility's peak load.

To decide whether a battery can be reused in the same application, in another application or cannot be used at all there is a need for a quick, economical and accurate way of identifying the health of such a used automotive battery.

In DE102013218081A1 a monitoring device for monitoring a state of a battery module is disclosed wherein the monitoring device includes a rapid discharge device which is provided for discharging the battery module with a predetermined discharge current and wherein the rapid discharge device comprises a power semiconductor and a resistor connected between the positive battery module pole and the negative battery module pole of the battery module.

## Summary of the Invention

It is an object of the present invention to provide systems, methods and component parts for measuring a characteristic of batteries or other energy storage devices which is practical equipment. An advantage of embodiments of the present invention is the provision of systems, methods and component parts for measuring a characteristic of high voltage batteries, e.g. 0.1 to 1 kV and/or automotive batteries as used in electric or hybrid automobiles. An advantage of embodiments of the present invention is the provision of systems, methods and component parts for performing a battery diagnostic test, for example on high voltage batteries, e.g. 0.1 to 1 kV, and/or automotive batteries as used in electric or hybrid automobiles. One such characteristic or diagnostic parameter is the impedance of such batteries and one such method is impedance spectroscopy testing.

In an aspect of the present invention, a characteristic diagnosing device, according to claim 1, is provided for an energy storage device, high voltage battery or an automotive battery, these being separable in a first and a second part which are either in series or in parallel, with Ohmic connections to poles of the first and second parts, the characteristic diagnosing device comprising: connectors for connecting the characteristic diagnosing device to the Ohmic connections, power processing means adapted to extract a current from the first part and to inject that current into the second part at at least one frequency; and

means for performing a characteristic diagnostic test on at least one part or on each part. By making use of power from the energy storage device to be tested, there is no need for a heavy external power source.

The means for performing a characteristic diagnostic test can be an impedance spectroscopy device. Impedance spectroscopy is very useful for checking the state of health of a battery.

The power processing means can be adapted to provide current at a plurality of frequencies. The plurality of frequencies can cover a range of 5 $\mu$Hz to 100 kHz. Using several frequencies improves the ability to diagnose a state of health of a battery.

The power processing means can be adapted to excite at least one or each of the first and second parts with two or more different waveforms selected from the group sinusoidal, a square or triangle wave, a sawtooth and DC-pulses. The power processing means is adapted to use pulse-width modulation. These waveforms are relatively easy to produce and provide important information about a battery when used in an impedance spectroscopy measurement.

The characteristic diagnosing device can include a voltage or current converter, for example a dc-dc or dc-ac converter. The power processing means can be adapted to produce the one or more different waveforms on the condition that the maximum frequency of the waveform is or is approximately one tenth of a switching frequency of the dc-dc or dc-ac converter. Use of a converter allows difference in voltages of the various parts to be equalized. An asymmetric triangular wave form at the switching frequency is also possible as this is the inherent waveform produced by the converter, but its shape is determined by the battery voltage.

A filter can be attached or coupled to the power processing means to reduce or suppress (sub)harmonics, of the kind able to disturb the characteristic diagnostic test.

In embodiments of the present invention a first part of a battery is fed with charging current from a second part of the battery, if necessary via a converter such as a dc-dc or dc-ac converter during testing, e.g. impedance testing. So the charge injected by the first part charges the second part and is stored in the second part thus there is little loss of energy or the first part is charged. This differs from known devices that use the voltage from the whole of the battery to test the battery. In that case energy is wasted in a discharge resistor for example. Such a resistor may need to be designed to dissipate very large amounts of energy and hence is of a large size and requires cooling power. Hence this is not a good solution for a handheld device nor is it a good solution for an automobile that has to carry this extra weight.

By utilising the energy from one part to drive the other part of the battery during a diagnostic test means that with the present invention it is possible to discharge and charge the battery at several kW without wasting energy in resistive losses, and without the extra weight of the fans and a large heatsink required to cool this resistor.

As both charge and discharge are possible with the present invention at high currents with little loss of energy and no need for heavy equipment, negative and positive pulses, or a sinusoidal current diagnostic test can be applied centred around the origin rather than a sinusoidal current imposed with a DC offset. When applying DC-discharge pulses and sinusoidal currents according to embodiments of the present invention these can be centred around the zero without a DC offset being imposed.

In accordance with embodiments of the present invention the battery can be tested with DC charge and discharge pulses and a wide range of low and high AC frequencies separately, centred around zero current without an external power supply. This allows a straightforward interpretation of the measured results as DC and AC phenomena are isolated from each other. Diagnostic tests can be carried out by embodiments of the present invention at any particular State of Charge (SoC). In addition, the current profile, amplitude or frequency to be applied in a diagnostic test can be chosen freely. Hence, the present invention is able to apply a user defined current profile, test current amplitude and frequency or frequencies including either DC or AC test currents.

A supervisory controller can be provided which is adapted to control the power processing means. A local controller allows technicians to control the testing. For example, the supervisory controller can be adapted to control the current in each part so that the current in the first and second parts are identical but for the sign and/or so that the frequency of the current in the first and second parts is the same. Also, meters can be provided to measure a voltage and current imposed on the first and second parts.

The means for performing a characteristic diagnostic test on each part can be adapted to determine the impedance at the different frequencies of injected current. Obtaining values ate different frequencies allows better assessment of the state of health of a battery.

A memory can be provided to store measured voltage/current and determined impedance, both in function of time as in function of the frequency of the injected current. This allows the historical values to be recalled and to be used in any assessment of the state of health of a battery. To assist in such an assessment, a display function for displaying battery impedance at one of more frequencies of the injected current can be provided.

A test plug, can be provided for insertion in an intermediate or mid-position of the energy storage device or high voltage battery or automotive battery and for providing Ohmic connections to poles of the first and second parts. A dedicated plug can increase safety in use.

A network access function can be provided which can be used, for example for remote storing of information, access to an expert system for assessment of state of health of a battery and to allow third party consultation of test values.

Such a testing device can be used for diagnostic testing of a hybrid vehicle or an electric vehicle.

In another aspect a method of operating a computer based characteristic diagnosing device, according to claim 9, is provided for testing of an energy storage device, high voltage battery or automotive battery separable in a first and a second part, the first and second parts being in series or in parallel, with Ohmic connections to poles of the first and second parts.

The method includes connecting the characteristic diagnosing device to the Ohmic connections, extracting a current from the first part and injecting that current into the second part at at least one frequency; and performing a characteristic diagnostic test on at least the second part or extracting a current from the second part and injecting that current into the first part at at least one frequency and performing a characteristic diagnostic test on at least the first part. In particular, the characteristic diagnostic test can be an impedance spectroscopy test. The method preferably includes the step of injecting the current at a plurality of frequencies, whereby the plurality of frequencies can cover a range of 5 $\mu$Hz to 100 kHz.

The method can include the step of exciting each of the first and second parts with two or more different waveforms selected from the group sinusoidal, a square or triangle wave, a sawtooth, and DC-pulses. Such one or more different waveforms can be generated, preferably, on the condition that the maximum frequency of the waveform is or is approximately one tenth of a switching frequency of a dc-dc or dc-ac converter. An asymmetric triangular wave form at the switching frequency is also possible as this is the inherent waveform produced by the converter, but its shape is determined by the battery voltage.

The method may include the step of filtering to reduce or suppress (sub)harmonics, of the kind able to disturb a characteristic diagnostic test.

The method can include the step of controlling the injected current in each part so that the current in the first and second parts are the same but for the sign and/or so that the frequency of the current in the first and second parts is the same. The current will not be "the same but for the sign" when the battery parts have a different voltage. As no storage is foreseen in the diagnostic device, the power of both battery halves is preferably the same, so the part with the largest RMS voltage will have the lowest RMS current. The amplitude will thus be different at a single point in time. However, at different points in time both battery parts can be subjected to currents with identical amplitude, waveform and frequency.

The method can also include measuring a voltage and current imposed on the first and second parts. For example it can include determining the impedance of a part at the different frequencies of injected current.

The method can include storing in memory measured voltage/currents and determined impedances, both in function of time as in function of the frequency of the injected current and/or displaying measured impedances at one of more frequencies of the injected current.

The method preferably includes inserting a test plug in an intermediate or mid-position of the energy storage device, high voltage battery or automotive battery for providing Ohmic connections to poles of the first and second parts.

Any of the methods of the present invention can be implemented with the help of a computer program product which can be stored on a non-transitory signal storage means.

In one aspect, the present invention provides a handheld or portable battery diagnostic testing device and method of operating the same which is able to provide the role of the conventional bidirectional external power supply without itself including such a power supply. Hence, in an aspect of the present invention a system and method of operating the system is provided which is capable of delivering the required energy and power for a battery diagnostic test such as an impedance spectroscopy test while the system or method only requires a portable or handheld device to achieve this. Particular embodiments of the present invention include making use of power from a part of a battery to inject testing current into another part of the same battery.

The most demanding application of the impedance spectroscopy measurement is the injection of a low frequency current. An option of embodiments of the present invention is for an energy storage system firstly to store a certain amount of energy followed by the delivery of an amount of this energy from the storage system to the battery to be tested.

For example, a 0.1 Hz current injection with an amplitude of 10 A could be injected into a 600 V battery. A triangular-shaped current injection could be selected as this is the common shape of the injected converter current due to the inductor of the dc-dc converter, but this is just an example for ease of calculation. The actual waveform can be a sinusoid, a square or triangle wave, a sawtooth, or a DC-pulse, etc. The peak power that needs to be delivered is 6 kW. The energy comprised in half a cycle of the triangle is 30 kJ or 8.3 Wh.

Embodiments relate to diagnosing, preferably with a portable or handheld device, for an automotive power battery whether the automotive power battery can be reused, possibly could be used for a different application, or must be disposed of, by diagnosing if the battery has fallen below regulatory standards for use in on-road vehicles. Even if below regulatory standards, embodiments of the present invention can diagnose whether such batteries like lithium-ion batteries still hold a significant charge level and, thus, can have additional economic value that can be recovered in a related or different application. For example, reuse in vehicles is possible as damaged cells may simply be replaced or a smaller or lighter or slower vehicle can be sought for use with the battery.

**Brief Descriptions of the figures**

Fig. 1 shows an overview of an electric vehicle to which embodiments of the present invention can be applied.

Fig. 2 shows an initial configuration of the high voltage battery when connected to the converters and inverters in accordance with an embodiment of the present invention.

Fig. 3 shows connection of both battery halves to the impedance spectroscopy measurement device in accordance with an embodiment of the present invention.

Fig. 4 shows an internal overview of a measurement device in accordance with an embodiment of the present invention.

Fig. 5 shows a configuration with single voltage and current measurement, impedance measurement of upper battery half in accordance with an embodiment of the present invention.

Fig. 6 shows a configuration with single voltage and current measurement, impedance measurement of lower battery half in accordance with an embodiment of the present invention.

Fig. 7 shows an overview of a device with measurement equipment, power processing equipment, supervisory controller to control the power equipment, to determine the battery characteristics in accordance with an embodiment of the present invention.

Fig. 8 shows an overview of a device with measurement equipment, power processing equipment, supervisory controller to control the power equipment, to determine the battery characteristics and to store both the measurement data as well as the determined battery characteristics as well as a display in accordance with an embodiment of the present invention.

Figure 9 shows a handheld device with communication facilities and link to database in accordance with an embodiment of the present invention.

Fig. 10 shows a connection of both battery halves to an individual converter with common dc-bus in accordance with an embodiment of the present invention.

**Definitions**

The term **"handheld"** relates to the ability of a person to carry a device like a battery diagnostic device and to manipulate the device even in the confined space of an automotive vehicle. Such a device will weigh less than 5 kg, and preferably be between 500 g and 2 kg, and the dimensions will preferably be less than 400 mm x 400 mm, i.e. an area of less than $16 \times 10^4$ mm$^2$ and preferably less than $10 \times 10^4$. It will be larger than $10^4$ mm$^2$.

The term **"portable"** relates to the ability of a device like a battery diagnostic device to be transported by normal automotive vehicles. Such a device will weigh less than 50 kg, and preferably be between 10 and 20 kg and the dimensions will preferably be less than 1 m x 1m x 500mm.

The term **"automotive battery"** or **"high voltage battery"** refers to a battery for use in an electric vehicle or hybrid vehicle that is a main power source for driving an electric motor that will propel the vehicle. Such a battery should not be confused with a 12 or 24 voltage battery that is customarily used as a power source in automobiles to start the engine and to run the lights when the motor and a generator attached thereto are not running. The automotive battery will for example provide a voltage between 0.1 and 1 kV. It will have an ampere-hour rating of at least 5 Ah up to several hundred Ah, e.g. 210Ah. An example is 72 cells of Sanyo at 5 Ah/3.7 V per cell in an Audi Q5/A6/A8 hybrid, see also "Lithium-Ion Batteries: Advances and Applications", Gianfranco Pistoia, Elsevier 2014, ISBN 978-0-444-59513-3, page 210.

A **"hybrid vehicle"** or **"hybrid automobile"** is a vehicle (such as, for example, an automobile, a train, a bus, a wagon, a lorry, a fork lift truck) that uses two or more distinct power sources to move the vehicle whereby one of the power sources is one or more electric motors or high voltage electric motors powered by one or more automotive batteries or high voltage batteries. The other drive may be, for example, a conventional internal combustion engine.

The term **"hybrid electric vehicles"** (HEVs), refers to a vehicle that combines an internal combustion engine and one or more electric motors. Other similar vehicles can be powered by both a diesel engine and an electric motor. A hybrid vehicle also includes a submarine that uses an internal combustion engine such as a diesel engine to power the propellers and one or more batteries that power an "E-motor" or electric motor when the submarine is submerged. It also includes aircraft such as a drone that has a similar combination of an electric motor with another power source.

**Description of the illustrative embodiments**

The present invention will be described with respect to particular embodiments and with reference to certain drawings but the invention is not limited thereto but only by the claims. The drawings described are only schematic and are non-limiting.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein. The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B. Similarly, it is to be noticed that the term "coupled", also used in the description or claims, should not be interpreted as being restricted to direct connections only. Thus, the scope of the expression "a device A coupled to a device B" should not be limited to devices or systems wherein an output of device A is directly connected to an input of device B. It means that there exists a path between an output of A and an input of B which may be a path including other devices or means.

References to software can encompass any type of programs in any language executable directly or indirectly by a processor.

References to logic, hardware, processor or circuitry can encompass any kind of logic or analog circuitry, integrated to any degree, and not limited to general purpose processors, digital signal processors, ASICs, FPGAs, discrete components or transistor logic gates and so on.

In embodiments of the present invention a first part of a battery is fed with charging current from a second part of the battery, if necessary via a dc-dc or dc-ac converter during testing, e.g. impedance testing. So the charge injected by the first part is stored in the second part thus there is little loss of energy. This differs from known devices that use the voltage from the whole of the battery to test the battery. In that case energy is wasted in a discharge resistor for example. Such a resistor may need to be designed to dissipate very large amounts of energy and hence is of a large size and requires cooling power. Hence this is not a good solution for a handheld device nor is it a good solution for an automobile that has to carry this extra weight.

By utilising the energy from one part to drive the other part of the battery during a diagnostic test means that with the present invention it is possible to discharge and charge the battery at several kW without wasting energy in resistive losses, and without the extra weight of the fans and a large heatsink required to cool this resistor.

As both charge and discharge are possible with the present invention at high currents with little loss of energy and no need for heavy equipment, negative and positive pulses, or a sinusoidal current diagnostic test can be applied centred around the origin rather than a sinusoidal current imposed with a DC offset. When applying DC-discharge pulses and sinusoidal currents these should be centred around the zero without a DC offset being imposed. A DC-offset in an impedance spectroscopy test alters the test. Combining DC and AC frequencies in a single impedance spectroscopy test can cause several phenomena to occur simultaneously, thus making it hard to relate the measured results to the correct underlying phenomena.

In accordance with embodiments of the present invention the battery can be tested with DC charge and discharge pulses and a wide range of low and high AC frequencies separately, centred around zero current without an external power supply. This allows a straightforward interpretation of the measured results as DC and AC phenomena are isolated from each other. Also batteries are known to have different charge and discharge characteristics at different values of state of charge (SoC). Hence using an AC test current with a DC offset whereby there is only discharge can falsify results. Diagnostic tests can be carried out by the present invention at any particular SoC. In addition, the user is free to choose the current profile, amplitude or frequency to be applied in a diagnostic test. Hence, the present invention is able to apply a user defined current profile, test current amplitude and frequency or frequencies including either DC or AC test currents.

Embodiments of the present invention meet an object of the invention to solve at least one problem relating to testing of an energy storage device such as a high voltage battery, e.g. 0.1 to 1 kV and/or an automotive battery, e.g. as used in electric or hybrid automobiles, by splitting the energy storage device such as the high voltage battery, e.g. 0.1 to 1 kV and/or the automotive battery, e.g. as used in electric or hybrid automobiles, into two or more parts, e.g. into two halves. The two or more parts of the storage device or battery may be connected in series when in normal operation or they can be connected in parallel. The only requirement is that one part of the storage device or battery should be powerful enough to drive diagnostic tests on the other or any other part. Hence, one part or half is adapted to deliver power while another part or the second half stores power during the first half cycle of the injected current and vice versa during the second half cycle. As both or all parts or halves exchange power and energy with one another while not requiring an external power supply, further energy storage can be omitted, diagnostic testing device such as an impedance spectroscopy diagnostic device for testing of an energy storage device or battery can be drastically reduced in size such that it can be a handheld or portable device. Both or all parts or halves do not need to be identical; differences in the number of cells, voltage, etc. are allowed as the connection between both or all can be arranged to be through at least one dc-dc converter or dc-ac converter which takes care of the voltage differences.

Embodiments of the present invention reduce the mass of the components needed to be carried to a vehicle. Also a very cooling power would be required. Embodiments of the present invention are able to discharge and charge a battery at several kW by recuperating power from one part of a battery in another part. Embodiments of the present invention do not require fans for cooling ,e.g. of a discharge resistor. Nor is a large heatsink required to protect an operator from heat generated by such a resistor resistor.

## Embodiment 1

This embodiment of the present invention meets an object of the invention and solves at least one problem relating to testing of an energy storage device by splitting the energy storage device such as the high voltage battery, e.g. 0.1 to 1 kV and/or the automotive battery, e.g. as used in electric or hybrid automobiles, into two or more parts, e.g. into two halves. The two or more parts of the energy storage device such as the high voltage battery, e.g. 0.1 to 1 kV and/or the automotive battery, e.g. as used in electric or hybrid automobiles may be connected in series when in normal operation or they can be connected in parallel. The only requirement is that one part of the energy storage device such as the high voltage battery, e.g. 0.1 to 1 kV and/or the automotive battery, e.g. as used in electric or hybrid automobiles should be powerful enough to drive diagnostic tests on the other or any other part by injecting current. Hence, one part or half is adapted to deliver power for a diagnostic test on the other or another part. The another part or the second half can store power during a first half cycle of the injected current and vice versa during the second half cycle.

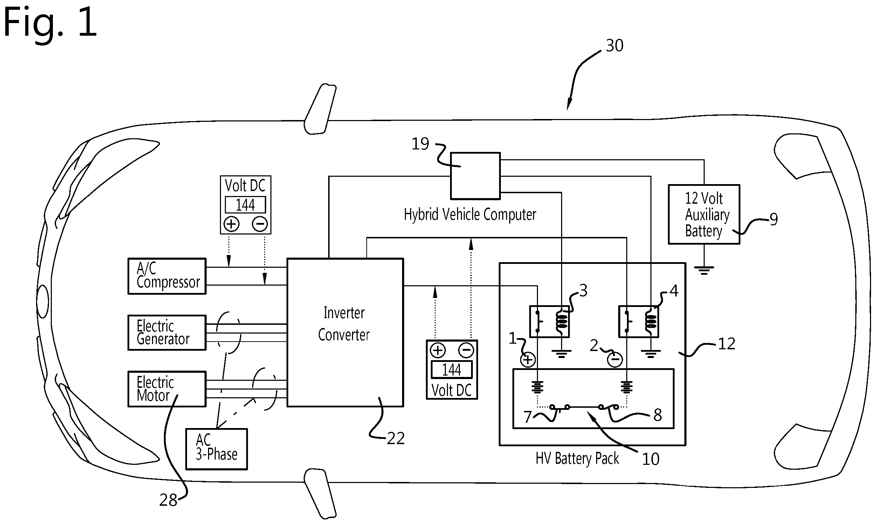

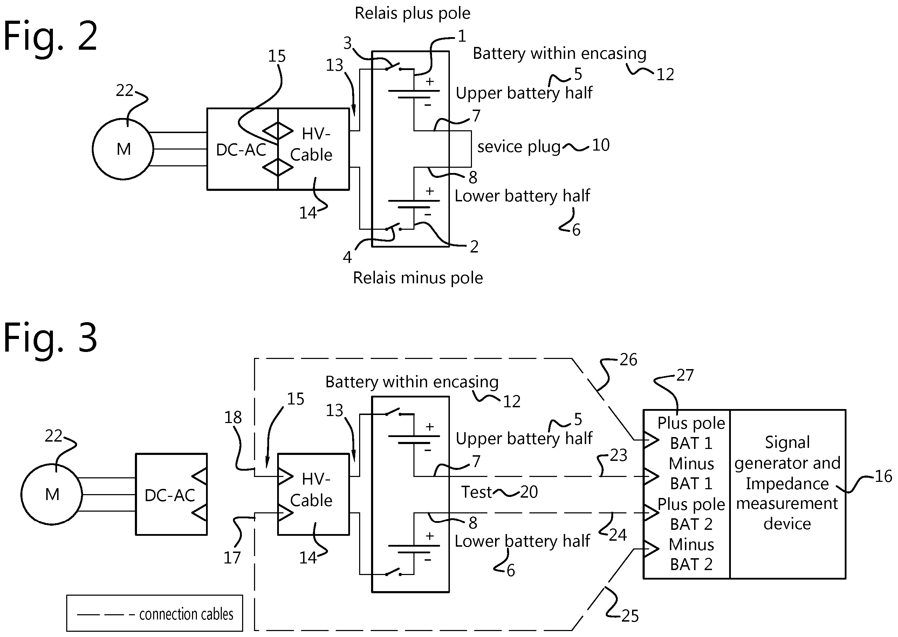

In order to achieve access to two or more battery parts or halves, both positive and negative poles of the energy storage device such as the high voltage battery, e.g. 0.1 to 1 kV and/or the automotive battery, e.g. as used in electric or hybrid automobiles and the middle or another split position of the energy storage device such as the high voltage battery, e.g. 0.1 to 1 kV and/or the automotive battery, e.g. as used in electric or hybrid automobiles need to be accessible for Ohmic contacts - see Figs. 1 and 2. In the following embodiments of the present invention will be described with reference to a battery but it should be understood that the term "battery" is simply a shortened version of "energy storage device such as a high voltage battery, e.g. 0.1 to 1 kV and/or an automotive battery, e.g. as used in electric or hybrid automobiles".

For example as shown in Figure 1 [7], the battery 12 of a Toyota Yaris Hybrid vehicle is an example of the use of such a high voltage battery 12 in Toyota's "Hybrid Synergy Drive". Such a car 30 has the normal 12 volt battery as an auxiliary battery 9 and a larger power battery 12 for powering the electric traction motor 28. Both poles 1, 2 of the battery 12 are connected to normally open relays 3, 4 to ensure that the wires and dc-bus of the inverter and dc-dc converter, i.e. inverter/converter module 22, are only live when the vehicle 30 is operational. The middle or split point of the battery 12 is accessible through a "service plug" 10 (better shown in Fig. 2) that divides the battery 12 in two parts or two halves 5, 6 to allow technicians and emergency responders to cut the current in case of maintenance or an emergency respectively.

More than one service plug 10 can be used to split the battery 12 at different positions.

A qualified technician can access the two Ohmic connection points 7, 8 in the middle of the battery 12 by removing the service plug 10 as a first step of the testing method. Access to the plus and minus poles 1, 2 of the battery 12 is thereby also made available. The access is used to connect to a diagnostic device 16 which is preferably a handheld or portable device as defined above. This access can either be achieved, in a first option, at the connector 13 (see Fig. 2) that joins the battery 12 to the high voltage cable 14 or in a second option at the connector 15 of the high voltage cable 14 that joins to the inverter/converter module 25. The first access option has the benefit of the access to the poles of the battery being near the service plug 10, such that the length of the wiring towards the battery diagnostic device 16 (see Fig. 3), such as an impedance spectroscopy measurement device, can be limited. The drawback is that this connector 13 might be difficult to access as it can require some disassembling in the trunk or boot of the vehicle to access or place this connector 13.

The second option is to use the connector 15 of the high voltage cable 14 to the inverter/converter module 22. This connector 15 is usually easy to access under the hood or bonnet of the vehicle, but requires longer wires because the service plug 10 can be located at the other end of the car 30. The removal of the service plug 10 will force the relays 3, 4 at the poles 1, 2 of the battery 12 to open, but this can be negated by sending the appropriate signals to a controller 19 (e.g. implemented as a computer or microcontroller or similar) of the relays 3, 4.

Some automotive power batteries such as the lithium-ion battery pack of the 2011 Nissan Leaf, have cells assembled into modules which may allow easier access to the poles 1, 2 at one or more split positions. Whatever technique is used, the required at least four Ohmic contact points 1, 2, 7, 8 are or can be made accessible [8].

The initial configuration of the battery 12 when connected to the inverter(s) in the inverter/converter module 22 of the electric traction motor(s) 28 is shown in Figure 2.

The reconfiguration of the high voltage battery 12 into two or more separately accessible battery parts or halves is shown in Fig. 3 and is a second step of the testing method. Both poles 1, 7; 2, 8 of both battery parts or halves 5, 6 are connected to a battery diagnostic device such as the battery impedance spectroscopy device 16. As shown in Fig. 3 the service plug 10 has been replaced with a test plug 20. From the test plug 20 cables 23 and 24 run to the input connection 27 of the rest of the diagnostic device 16 e.g. an impedance spectrometric test device. The cables 23, 24 connect the poles 7, 8, respectively, of the upper (5) and lower (6) parts of the battery 12 to the connection 27 and to the rest of the diagnostic device 16 e.g. an impedance spectrometric test device.

As also shown in Fig. 3, cables 25 and 26 run from the connector 15 at the end of the HV cable 14 and from connection points 17, 18 of the HV cable 14 to the input connection 27 of the diagnostic device 16 e.g. an impedance spectrometric test device. The cables 25, 26 provide connections to the poles 1, 2, respectively, of the battery 12 to the connection 27.

The diagnostic device 16, e.g. for carrying out an impedance spectrometric test, which is preferably handheld or portable, can include a signal generator and a battery characteristic measurement device such as an impedance spectroscopy measurement device. This arrangement as shown in Fig. 3 allows to draw power from one battery part or half 5, 6 and inject power into another or the other part or battery half 6, 5. The battery diagnostic device 16, which is preferably handheld or portable, and particularly the handheld battery impedance spectroscopy device is drastically reduced in size as it contains little or no electric energy storage capacity.

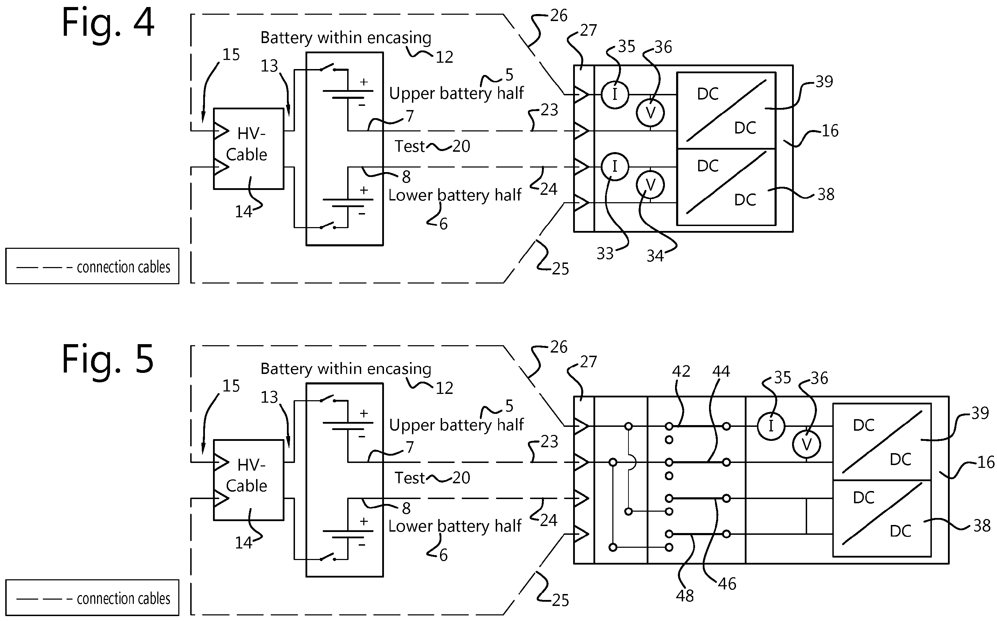

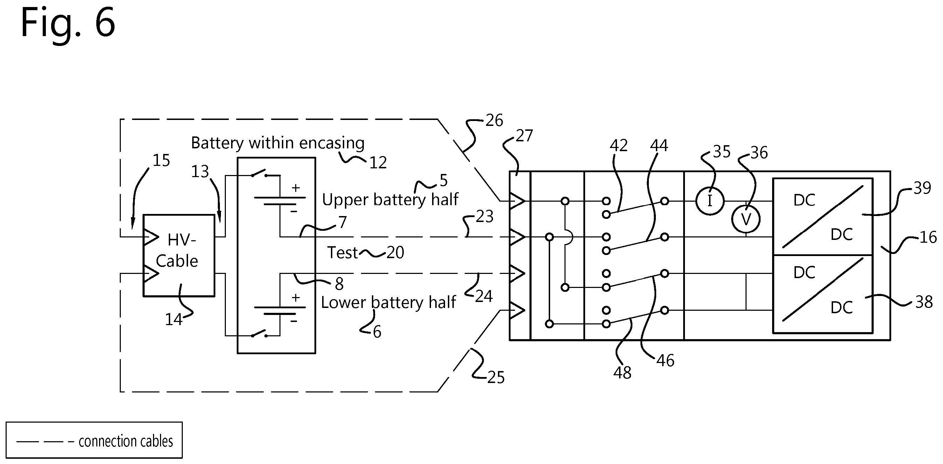

The battery diagnostic device 16 and for example the battery impedance spectroscopy measurement device, which is preferably handheld or portable, is equipped with the necessary measurement tools to measure the battery impedance. In the embodiment of Fig. 4 the battery diagnostic device 16, for example the handheld battery impedance spectroscopy measurement device, which is preferably handheld or portable, is equipped with two sets of current (33, 35) and voltage (34, 36) meters to determine the battery characteristic, e.g. impedance of each battery part or half 5, 6 as well as dc/dc or dc/ac converters 38, 39 for the upper battery part or half 5 and for the lower battery part or half 6, respectively. The dc-dc converters provide DC voltage and current, whereas the dc-ac converters can be connected to a rectifying circuit to produce DC voltage and current. In a variation of this embodiment only one set of a current (35) and voltage (36) meters is provided and switches are provided to switch the meters 35, 36 to the respective part or half of the battery. A configuration with a single set of voltage and current measurement meters 35, 36 with switches 42, 44, 46, 48 is shown in Figs. 5 and 6. By operating the switches 42, 44, 46, 48 the meters 35 and/or 36, can be switched in to perform a diagnostic test, e.g. an impedance measurement of the upper battery part or half 5 (Fig. 5) and an impedance measurement of the lower battery part or half 6 (Fig. 6).

As all or some or both battery parts or halves 5, 6 can differ in number of cells and/or voltage, the current through all or some or both parts or halves can also be different. Nevertheless, the diagnostic measurement such as the impedance measurement can be performed by a single set of voltage and current meters 35, 36 for example if the required number of switches, such as four switches 42, 44, 46, 48, are installed. These four switches 42, 44, 46, 48 allow a battery part or half 5, 6 to be connected to either one of the dc-dc or dc-ac converters 38, 39. The dc-dc or dc-ac converters 38, 39 are provided to adjust any voltages to regain a balanced system as required and illustrated in Fig. 5. This embodiment, having at least one voltage and current measurement device, can be beneficial to save volume, weight and cost. It is expressly included in any of the embodiments of the present invention.

The battery characteristic diagnostic device 16 such as the battery impedance spectroscopy measurement device, which is preferably handheld or portable, is preferably also equipped with a power processing stage or means which is able to extract the required current from one battery part or half and inject that current in another or the other battery part or half. An important concept of the present invention is to use a part of the battery as a power source to test another or the other part. For this reason, the battery characteristic diagnostic device, e.g. for carrying out an impedance spectrometric test according to any of the embodiments, which is preferably handheld or portable, does not require a powerful external power supply. The power processing stage or means is adapted to provide the required battery current at at least one frequency, but preferably is able to provide the required current at a broad range of frequencies, such as the range 5 $\mu$Hz to 100 kHz see, for example http://www.electrochemsci.org/papers/vol7/7010345.pdf, or http://www.fuelcon.com/cms/ en/news/index.php?id=battery _impedance_spectroscopy &L= 1

The power processing stage or means is preferably able to excite each of the battery parts or halves with two or more different waveforms such as a sinusoidal, a square or triangle wave, a sawtooth, or a DC-pulse, etc. This is possible through techniques such as pulse-width modulation which allow to produce the mentioned waveforms on the condition that the maximum frequency of the waveform is approximately one tenth of the switching frequency of the dc-dc or dc-ac converter. This switching frequency is technology dependent. An IGBT based converter will have a typical switching frequency of 20 kHz and can produce the mentioned waveforms up to 2 kHz, while a SiC based converter can switch at up to 500 kHz to 1 MHz and produce the mentioned waveforms up to 100 kHz. This list is not exhaustive, technologies such as MOSFETs, COOLMOS, etc. should also be considered, albeit the maximum allowable battery voltage is also technology dependent. The low frequency waveforms (hHz range, Hz range, mHz range) are easy to attain with all switching technologies.

The battery characteristic diagnostic device 16, e.g. for carrying out an impedance spectrometric test, which is preferably handheld or portable, can be equipped with a filter stage (not shown) attached to the power processing stage or means to prevent or reduce unwanted (sub)harmonics, originating from e.g. the power processing stage, from reaching the battery and disturbing the impedance measurement.

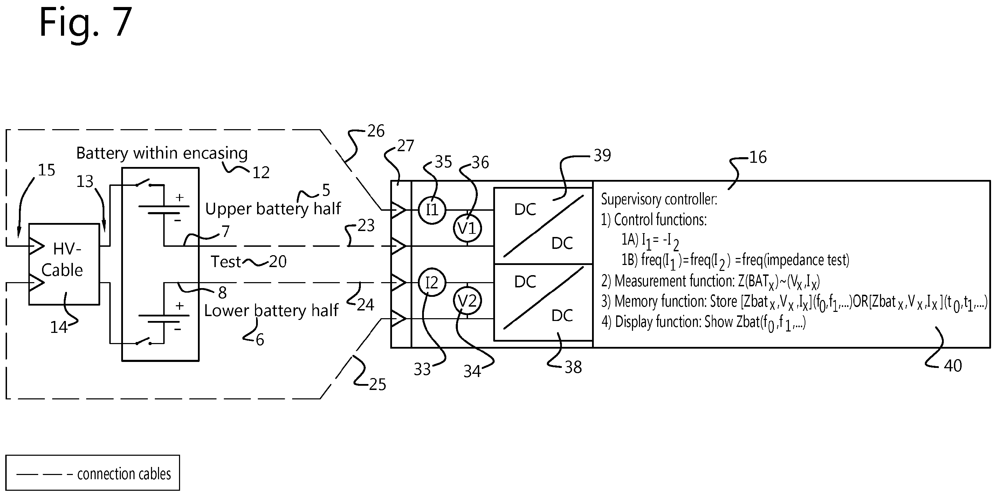

Fig. 7 shows an overview of the device with measurement equipment, power processing equipment, and supervisory controller to control the power equipment, to determine the battery characteristics and to store both the measurement data as well as the determined battery characteristics. The handheld battery characteristic diagnostic device, e.g. for carrying out an impedance spectrometric test, which is preferably handheld or portable, is also preferably equipped with a supervisory controller 40, as shown schematically in Fig. 7 .

For example, the supervisory controller 40 can be adapted to control the power processing stage or means, such that the current in both or all parts or halves of the battery 12 are (nearly) identical but for the sign. The supervisory controller 40 can also be adapted to make sure that the frequency of the currents in both or all parts or halves of the battery 12 are the same during diagnostic testing by controlling the power processing stage or means, e.g. if required by taking the influence of a filter stage into account.

The battery characteristic diagnosing device 16, e.g. for carrying out an impedance spectrometric test, which is preferably handheld or portable, can be equipped with a processing engine such as a microprocessor of a CPU, or a microcontroller adapted to facilitate measurement of the voltage and current in each battery part, preferably with the required level of accuracy, and to facilitate the determination of relevant battery characteristics such as the impedance at the different frequencies of the injected current based on these measurements. Based on the measured voltage, current and impedance, the processing engine can be adapted to perform estimations on the state of charge (SoC), state of health (SoH ) and other battery characteristics.

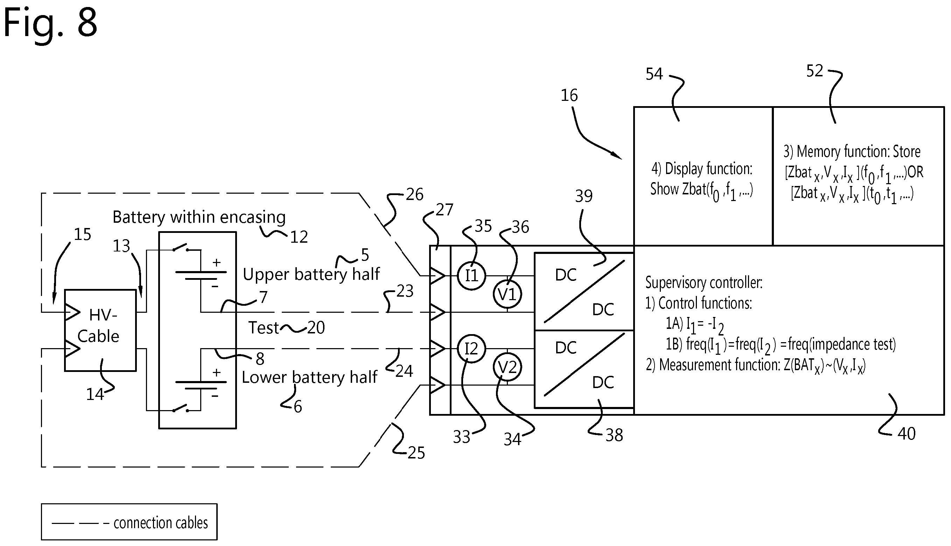

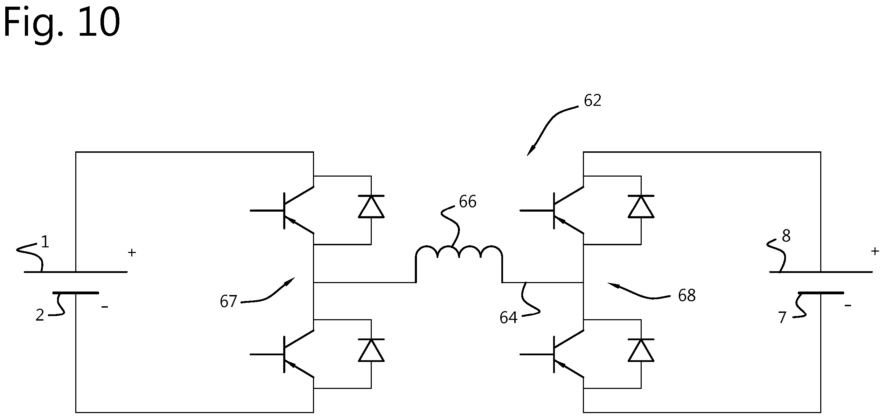

As shown in Fig. 8, the battery characteristic diagnosing device16, e.g. for carrying out an impedance spectrometric test, which is preferably handheld or portable, can also be equipped with memory storage (52, see Fig. 10) to store the measured voltage/current and determined impedance, both in function of time as in function of the frequency (of the injected current).

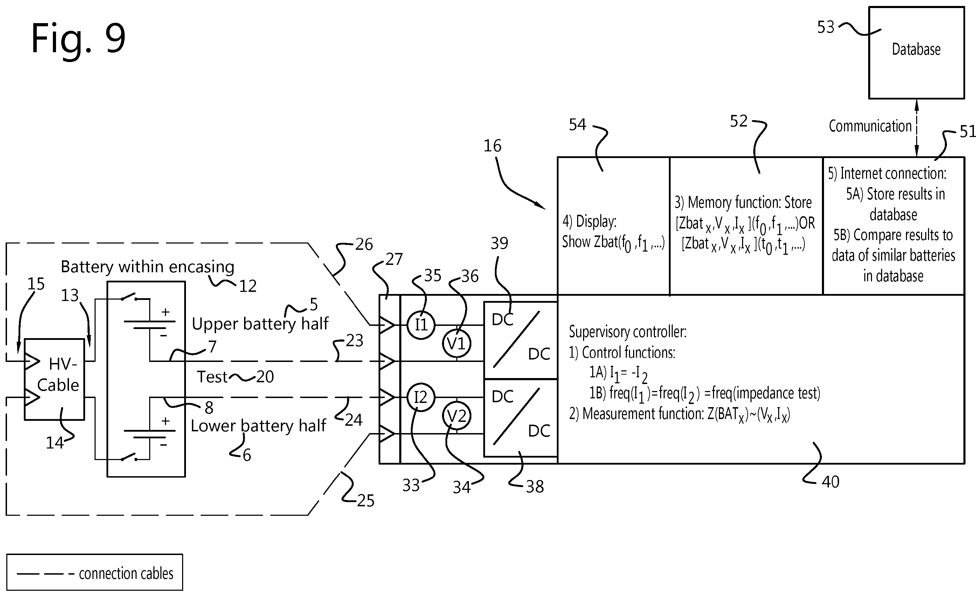

The battery characteristic diagnosing device, which is preferably handheld or portable, can also be equipped with a display function (54) (see Fig. 9) that shows, amongst others for example, the battery impedance at the different frequencies.

As both or all battery parts or halves of the battery according to this embodiment exchange power and energy with one another, the characteristic diagnosing device16, e.g. for carrying out an impedance spectrometric test, which is preferably handheld or portable, does not require an external power supply. Thus further energy storage equipment can be omitted, and a battery diagnostic testing device such as an impedance spectroscopy diagnostic device according to this embodiment can be drastically reduced in size, such that it is a handheld or portable device. Both or all parts or halves do not need to be identical; differences in the number of cells, voltage, etc. are allowed as the connection between both or all can be arranged to be through at least one dc-dc or dc-ac converter which takes care of the differences.

## Embodiment 2

With reference to Figure 10 a battery characteristic diagnosing device 16, e.g. for carrying out an impedance spectrometric test, which is preferably handheld or portable, as described above may be adapted to communicate with other devices, and to connect to a network, e.g. for remote assistance. For this purpose, it may be provided with a wireless or wired network card and networking ability 51. In particular, the battery characteristic diagnosing device 16, e.g. for carrying out an impedance spectrometric test, which is preferably handheld or portable, as described above can access a central database 53, e.g. in a database server connected to the network. The central database or databases 53 may store details of each automotive battery sold and in use. The results of diagnostic testing of batteries as described with respect to embodiments of the present invention can be stored for each battery in such a database. Such data may be provided when the automotive vehicle is to be sold with its battery. The records of impedance measurement may also be used to determine if the battery passes regulatory test specifications. The data can also be used to retrieve data on similar battery packs and compare/display the retrieved data with the measured data of the battery pack under test.

The central database 53 may also include an expert system which collects all test results and creates from these results heuristic rules to provide assistance in deciding the fate of a battery, e.g. reuse, repair, diversion to a different application or destruction.

## Embodiment 3

This further embodiment may be included with any of the previous embodiments and these combinations are each explicitly disclosed. A configuration of this further embodiment of the present invention to achieve the energy exchange between all or both parts or halves of a battery is illustrated in Fig. 9 schematically. This shows a connection of both battery parts or halves 5, 6 to an individual converter 62 with common dc-bus 64. The plus poles 1, 8 of each battery part or half 5, 6 are connected to a bidirectional boost converter 62. The minus poles 2, 7 are connected to the common minus of all or both battery parts or halves 5, 6 and converters 67, 68. Each dc-dc converter 67, 68 can independently draw or inject current from the battery to the dc-bus 64 of the converters 67, 68 and an inductance 66. In order to minimize the dc-bus capacity, the supervisory controller 40 can be adapted to make sure the current drawn by one converter is injected by the other converter. This forces the required battery impedance spectroscopy current to flow through both battery parts 5, 6.

This embodiment can also be attained using other bidirectional converters such as, amongst others, the bidirectional cuk converter [10] and the bidirectional flyback converter [11]. The main requirement is that the converter 67, 68 allows bidirectional currents.

The exchange of energy between both battery parts can also be attained using a single bidirectional buck-boost converter. The benefit of this converter is its ease of operation (see http://www.diva-portal.org/smash/get/diva2:301346/FULLTEXT01.pdf). From a hardware point of view the capacitor can be omitted, while the filters are no longer strictly required as the common link between both half bridges is an inductor. Both parts of the battery are allowed to have a higher or lower voltage than the other part using this single converter. Converter is without capacitor and filters, and a single inductor is used as a dc-link.

Automotive bidirectional dc-dc converters can go up to 5.3 kW/kg and 9.1 kW/l [10] when used between the high voltage battery and the high voltage dc-bus of the motor inverters. Each converter connected to one of the battery halves would thus weigh at around 1 kg and have a volume of 0.5 liter to inject a 10 A current in a 600 V battery. The total power processing stage, including the filter stage, thus would weigh at around 2 kg and have a volume of 1 liter. This would be the main contribution in mass and volume of the device, as the display, processing engine such as a CPU, memory and measurement components add little weight compared to the power processing stage and its filters.

A comparison of this mass and volume to the previously mentioned data, shows that embodiments of the present invention are able to reduce the mass from 8-9 kg of a conventional diagnostic device with supercapacitor/battery to some 2 kg, which is a significant advantage for a handheld device. Furthermore, the cost is decreased as the most expensive elements can be omitted, while the reliability also increases due omitting of the external energy supply such the supercapacitor/battery.

## Implementation

Embodiments of the present invention describing a battery characteristic diagnosing device, e.g. for carrying out an impedance spectrometric test, which is preferably handheld or portable, can be implemented by a digital device with processing capability including one or more microprocessors, processors, microcontrollers, controllers, or central processing units (CPU) and/or a Graphics Processing Units (GPU), and can be adapted to carry out the respective functions or tests by being programmed with software, i.e. one or more computer programs.

Such a battery characteristic diagnosing device 16, e.g. for carrying out an impedance spectrometric test, which is preferably handheld or portable, may have memory (such as non-transitory computer readable medium, RAM and/or ROM), an operating system, such as Windows™, Linux™ or Android™ optionally a display such as a fixed format display such as an OLED display, data entry devices such as a keyboard, a pointer device such as a "mouse", serial or parallel ports to communicate with other devices, network cards and connections to connect to a network, e.g. for remote assistance.

The software can be embodied in a computer program product adapted to carry out the following functions when the software is loaded onto the respective device or devices and executed on one or more processing engines such as microprocessors, ASIC's, FPGA's etc., for carrying out a method of operating a computer based battery characteristic diagnosing device on an energy storage device such as an automotive battery separable in a first and a second battery part, the first and second parts being in series or in parallel, with Ohmic connections to poles of the first and second parts for connecting the battery characteristic diagnosing device to the Ohmic connections.

The software embodied in the computer program product is adapted to carry out the following functions when the software is loaded onto the respective device or devices and executed on one or more processing engines such as microprocessors, ASIC's, FPGA's etc.:

extracting a current from the first part and injecting that current into the second part at at least one frequency; and performing a battery characteristic diagnostic test on at least the second battery part or extracting a current from the second battery part and injecting that current into the first battery part at at least one frequency and performing a battery characteristic diagnostic test on at least the first battery part.

The battery characteristic diagnostic test can be a battery impedance spectroscopy test.

The software embodied in the computer program product is adapted to carry out the following functions when the software is loaded onto the respective device or devices and executed on one or more processing engines such as microprocessors, ASIC's, FPGA's etc.: injecting the current at a plurality of frequencies. The plurality of frequencies can cover a range of 5 $\mu$Hz to 100 kHz.

The software embodied in the computer program product is adapted to carry out the following functions when the software is loaded onto the respective device or devices and executed on one or more processing engines such as microprocessors, ASIC's, FPGA's etc.:

exciting each of the first and second parts with two or more different waveforms selected from the group sinusoidal, a square or triangle wave, a sawtooth and DC-pulses, for example producing the one or more different waveforms on the condition that the maximum frequency of the waveform is or is approximately one tenth of a switching frequency of a dc-dc or dc-ac converter. An asymmetric triangular wave form at the switching frequency is also possible as this is the inherent waveform produced by the converter, but its shape is determined by the battery voltage.

The software embodied in the computer program product is adapted to carry out the following functions when the software is loaded onto the respective device or devices and executed on one or more processing engines such as microprocessors, ASIC's, FPGA's etc.:

filtering to reduce or suppress (sub)harmonics, of the kind able to disturb a battery characteristic diagnostic test.

The software embodied in the computer program product is adapted to carry out the following functions when the software is loaded onto the respective device or devices and executed on one or more processing engines such as microprocessors, ASIC's, FPGA's etc.:

controlling the injected current in each part of the battery so that the current in the first and second parts are the same but for the sign and/or so that the frequency of the current in the first and second parts is the same. Obviously, the current will not be "the same but for the sign" when the battery parts have a different voltage. As no storage is foreseen in the device, the power of both battery halves needs to identical, so the part with the largest RMS voltage will have the lowest RMS current. The amplitude will thus be different at a single point in time. However, at different points in time both battery parts can be subjected to currents with identical amplitude, waveform and frequency.

The software embodied in the computer program product is adapted to carry out the following functions when the software is loaded onto the respective device or devices and executed on one or more processing engines such as microprocessors, ASIC's, FPGA's etc.:

measuring a voltage and current imposed on the first and second battery part.

The software embodied in the computer program product is adapted to carry out the following functions when the software is loaded onto the respective device or devices and executed on one or more processing engines such as microprocessors, ASIC's, FPGA's etc.:

determining the impedance of a part at the different frequencies of injected current.

The software embodied in the computer program product is adapted to carry out the following functions when the software is loaded onto the respective device or devices and executed on one or more processing engines such as microprocessors, ASIC's, FPGA's etc.:

storing in memory measured voltage/currents and determined impedances, both in function of time as in function of the frequency of the injected current, and/or displaying battery impedance at one of more frequencies of the injected current.

The computer program can be stored on a non-transitory signal storage such as an optical disk (CD-ROM or DVD-ROM), magnetic disk, magnetic tape, or solid state memory such as a flash drive, or similar.

References:

[1] https://portalvhds963slh4m3fqg2.blob.core.windows.net/megger-products/BITE3_DS_EN_V21.pdf
[2] http://www.artecing.com.uy/pdf/guias_megger/New%20-%20BatteryTestingGuide_en_LR.pdf
[3] http://www.cadex.com/_content/Capacity_vs_CCA3.pdf
[4]http://www tester.co.uk/downloads/dl/file/id/2660/extech bt100 battery tester datasheet .pdf
[5] http://www.tester.co.uk/downloads/dl/file/id/2116/fluke_bt500_series_battery_analysers_da tasheet. pdf
[6] http://www.victronenergy.nl/upload/documents/Datasheet-Quattro-3kVA-10kVA-NL.pdf
[7] Toyota Yaris Hybrid Emergency Response Guide
[8] http://artsautomotive.com/publications/7-hybrid/111-prius-1st-gen-replacing-transaxle/
[9] T. A. Burress, S. L. Campbell, C. L. Coomer, , C. W. Ayers, J. P. Cunningham, L. D. Marlino, L. E. Seiber, "EVALUATION OF THE 2010 TOYOTA PRIUS HYBRID SYNERGY DRIVE SYSTEM", Oak Ridge National Laboratory, Energy and Transportation Science Division, Tech. Rep., March 2011.
[10]Su-Won Lee, Seong-Ryong Lee, Chil-Hwan Jeon, "A New High Efficient Bi-directional DC/DC Converter in the Dual Voltage System", Journal of Electrical Engineering & Technology, Vol. 1, No. 3, pp. 343-350, 2006
[11] Prasanth Thummala, Zhe Zhang and Michael A. E. Andersen, "High Voltage Bi-directional Flyback Converter for Capacitive Actuator," 15th Conference on Power Electronics and Applications, EPE'13 ECCE Europe.

## Claims

1. A characteristic diagnosing device for an energy storage device, high voltage battery or an automotive battery separable in a first (5) and a second (6) part being in series or in parallel, with Ohmic connections to poles of the first and second parts, the characteristic diagnosing device comprising:

   • connectors (27) for connecting the characteristic diagnosing device to said Ohmic connections of both poles of both the first (5) and second (6) part after the separation of the energy storage device, the high voltage battery or the automotive battery,
   • power processing means configured to extract a current from the first part and to inject that current into the second part at at least one frequency after separating the first (5) and second (6) part of the energy storage device, the high voltage battery or the automotive battery into said first and second parts; and
   • means for performing a characteristic diagnostic test on at least one part or on each part,

   and wherein the power processing means is configured to excite at least one or each of the first and second parts with two or more different waveforms selected from the group of a sinusoidal, a square or triangle wave, a sawtooth and DC-pulses, or an asymmetric triangular wave form.

2. The characteristic diagnosing device according to claim 1, wherein the power processing means is configured to provide current at a plurality of frequencies or

   wherein the power processing means is configured to use pulse-width modulation, or wherein the power processing means is configured to extract a current from the first part and to inject that current into the second part at at least one frequency and is configured to utilise the energy from the first part to drive the second part of the battery, or
   the power processing means is configured to produce said different waveforms on the condition that the maximum frequency of the waveform is one tenth of a switching frequency of a dc-dc or dc-ac converter.

3. The characteristic diagnosing device according to any previous claim, further comprising a filter attached or coupled to the power processing means to reduce or suppress harmonics or subharmonics, of the kind able to disturb the characteristic diagnostic test.

4. The characteristic diagnosing device according to any previous claim, further comprising a supervisory controller configured to control the power processing means.

5. The characteristic diagnosing device according to claim 4, wherein the supervisory controller is configured to control the current in each part so that the current in the first and second parts are identical but for the sign and/or so that the frequency of the current in the first and second parts is the same.

6. The characteristic diagnosing device according to any previous claim, further comprising meters to measure a voltage and current imposed on the first and second parts and/or

wherein the means for performing a characteristic diagnostic test on each part is adapted to determine the impedance at the different frequencies of injected current, or
wherein the means for performing a characteristic diagnostic test is an impedance spectroscopy device.

7. The characteristic diagnosing device according to any previous claim, further comprising a test plug, for insertion in an intermediate or mid-position of the energy storage device or high voltage battery or automotive battery and for providing Ohmic connections to the poles of the first and second parts.

8. Use of the device according to any of the claims 1 to 7, for diagnostic testing of a hybrid vehicle or an electric vehicle.

9. A method of operating a computer based characteristic diagnosing device on an energy storage device, high voltage battery or automotive battery separable in a first (5) and a second (6) part, the first and second parts being in series or in parallel, with Ohmic connections to poles of the first and second parts, the method comprising:

   • connecting the characteristic diagnosing device to the Ohmic connections of both poles of both the first (5) and second (6) part after separating in the first (5) and second (6) part of the energy storage device, the high voltage battery or the automotive battery into said first and second parts,
   • extracting a current from the first part and injecting that current into the second part at at least one frequency after separating the first (5) and second (6) part of the energy storage device, the high voltage battery or the automotive battery into said first and second parts,
   • performing a characteristic diagnostic test on at least the second part or extracting a current from the second part and injecting that current into the first part at at least one frequency and performing a characteristic diagnostic test on at least the first part,

   further comprising the step of:

   • exciting each of the first and second parts with two or more different waveforms selected from the group of a sinusoidal, a square or triangle wave, a sawtooth and DC-pulses, or an asymmetric triangular wave form.

10. The method of claim 9 wherein injecting that current into the second part at the at least one frequency, charges the first or second part, and/or
feeds the second part of the battery with a charging current from the first part of the battery, via a dc-dc or dc-ac converter.

11. The method according to claim 9 or 10, wherein the characteristic diagnostic test is an impedance spectroscopy test.

12. The method according to any of the claims 9 to 11, further comprising the step of:
injecting the current at a plurality of frequencies.

13. The method according to claim 12, further comprising determining the impedance of a part at the plurality of frequencies of injected current.

14. The method of any of the claims 9 to 13, further comprising inserting a test plug in an intermediate or mid-position of the energy storage device, high voltage battery or automotive battery for providing Ohmic connections to the poles of the first and second parts.

15. A computer program product that, when executed on a processing engine, causes the characteristic diagnosing device of claim 1 to implement any of the methods of claims 9 to 14, or
a non-transitory signal storage means storing a computer program product that, when executed on a processing engine, causes the characteristic diagnosing device of claim 1 to implement any of the methods of claims 9 to 14.

**Patentansprüche**

1. Vorrichtung zur Eigenschaftsdiagnose für eine Energiespeichervorrichtung, Hochspannungsbatterie oder Kraftfahrzeugbatterie, die in einen ersten (5) und einen zweiten (6) Teil trennbar ist, welche in Reihe oder parallel geschaltet sind, mit ohmschen Verbindungen zu Polen des ersten und des zweiten Teils, wobei die Vorrichtung zur Eigenschaftsdiagnose umfasst:

   • Verbinder (27) zum Verbinden der Vorrichtung zur Eigenschaftsdiagnose mit den ohmschen Verbindungen beider Pole sowohl des ersten (5) als auch des zweiten (6) Teils nach der Trennung der Energiespeichervorrichtung, der Hochspannungsbatterie oder der Kraftfahrzeugbatterie,
   • Leistungsverarbeitungsmittel, die dafür ausgelegt sind, nach dem Trennen des ersten (5) und des zweiten (6) Teils der Energiespeichervorrichtung, der Hochspannungsbatterie oder der Kraftfahrzeugbatterie in den ersten und den zweiten Teil einen Strom aus dem ersten Teil zu extrahieren und diesen Strom in den zweiten Teil mit mindestens einer Frequenz zu injizieren; und
   • Mittel zum Durchführen eines Eigenschaftsdiagnosetests an wenigstens einem Teil oder an jedem Teil,

   und wobei das Leistungsverarbeitungsmittel dafür ausgelegt ist, wenigstens eines oder jedes von dem ersten und dem zweiten Teil mit zwei oder mehr unterschiedlichen Wellenformen zu erregen, die aus der Gruppe der Sinus-, Rechteck- oder Dreieckwellen, Sägezahn- und Gleichstromimpulse oder asymmetrischen dreieckigen Wellenformen ausgewählt sind.

2. Vorrichtung zur Eigenschaftsdiagnose nach Anspruch 1, wobei das Leistungsverarbeitungsmittel dafür ausgelegt ist, Strom mit mehreren Frequenzen zu liefern, oder wobei das Leistungsverarbeitungsmittel dafür ausgelegt ist, Pulsbreitenmodulation anzuwenden, oder

   wobei das Leistungsverarbeitungsmittel dafür ausgelegt ist, einen Strom aus dem ersten Teil zu extrahieren und diesen Strom in den zweiten Teil mit mindestens einer Frequenz zu injizieren, und dafür ausgelegt ist, die Energie vom ersten Teil zu verwenden, um den zweiten Teil der Batterie anzusteuern, oder
   das Leistungsverarbeitungsmittel dafür ausgelegt ist, unterschiedliche Wellenformen unter der Bedingung zu erzeugen, dass die maximale Frequenz der Wellenform ein Zehntel einer Schaltfrequenz eines Gleichspannungswandlers oder Wechselrichters ist.

3. Vorrichtung zur Eigenschaftsdiagnose nach einem der vorhergehenden Ansprüche, welche ferner ein Filter umfasst, das an dem Leistungsverarbeitungsmittel befestigt oder mit ihm gekoppelt ist, um Harmonische oder Subharmonische von der Art, die in der Lage ist, den Eigenschaftsdiagnosetest zu stören, zu reduzieren oder zu unterdrücken.

4. Vorrichtung zur Eigenschaftsdiagnose nach einem der vorhergehenden Ansprüche, welche ferner eine Überwachungssteuereinrichtung umfasst, die dafür ausgelegt ist, das Leistungsverarbeitungsmittel zu steuern.

5. Vorrichtung zur Eigenschaftsdiagnose nach Anspruch 4, wobei die Überwachungssteuereinrichtung dafür ausgelegt ist, den Strom in jedem Teil so zu steuern, dass der Strom im ersten und zweiten Teil bis auf das Vorzeichen identisch ist, und/oder so, dass die Frequenz des Stroms im ersten und zweiten Teil dieselbe ist.

6. Vorrichtung zur Eigenschaftsdiagnose nach einem der vorhergehenden Ansprüche, welche ferner Messgeräte umfasst, um eine Spannung und einen Strom zu messen, die an den ersten und zweiten Teil angelegt werden, und/oder

   wobei das Mittel zum Durchführen eines Eigenschaftsdiagnosetests an jedem Teil dazu eingerichtet ist, die Impedanz bei den verschiedenen Frequenzen des injizierten Stroms zu bestimmen, oder
   wobei das Mittel zum Durchführen eines Eigenschaftsdiagnosetests eine Impedanzspektroskopievorrichtung ist.

7. Vorrichtung zur Eigenschaftsdiagnose nach einem der vorhergehenden Ansprüche, welche ferner einen Prüfstecker zum Einsetzen in eine Zwischen- oder Mittelposition der Energiespeichervorrichtung oder Hochspannungsbatterie oder Kraftfahrzeugbatterie und zum Bereitstellen ohmscher Verbindungen zu den Polen des ersten und des zweiten Teils umfasst.

8. Verwendung der Vorrichtung nach einem der Ansprüche 1 bis 7 zum diagnostischen Testen eines Hybridfahrzeugs oder eines Elektrofahrzeugs.

9. Verfahren zum Betreiben einer computerbasierten Vorrichtung zur Eigenschaftsdiagnose an einer Energiespeichervorrichtung, Hochspannungsbatterie oder Kraftfahrzeugbatterie, die in einen ersten (5) und einen zweiten (6) Teil trennbar ist, wobei der erste und der zweite Teil in Reihe oder parallel geschaltet sind, mit ohmschen Verbindungen zu Polen des ersten und des zweiten Teils, wobei das Verfahren umfasst:

• Verbinden der Vorrichtung zur Eigenschaftsdiagnose mit den ohmschen Verbindungen beider Pole sowohl des ersten (5) als auch des zweiten (6) Teils nach dem Trennen im ersten (5) und zweiten (6) Teil der Energiespeichervorrichtung, der Hochspannungsbatterie oder der Kraftfahrzeugbatterie in den ersten und zweiten Teil,
• Extrahieren eines Stroms aus dem ersten Teil und Injizieren dieses Stroms in den zweiten Teil mit mindestens einer Frequenz nach dem Trennen des ersten (5) und des zweiten (6) Teils der Energiespeichervorrichtung, der Hochspannungsbatterie oder der Kraftfahrzeugbatterie in den ersten und den zweiten Teil,
• Durchführen eines Eigenschaftsdiagnosetests an wenigstens dem zweiten Teil oder Extrahieren eines Stroms aus dem zweiten Teil und Injizieren dieses Stroms in den ersten Teil mit mindestens einer Frequenz und Durchführen eines Eigenschaftsdiagnosetests an wenigstens dem ersten Teil,

und ferner den Schritt umfasst:

• Erregen jedes von dem ersten und dem zweiten Teil mit zwei oder mehr unterschiedlichen Wellenformen, die aus der Gruppe der Sinus-, Rechteck- oder Dreieckwellen, Sägezahn- und Gleichstromimpulse oder asymmetrischen dreieckigen Wellenformen ausgewählt sind.

10. Verfahren nach Anspruch 9, wobei das Injizieren dieses Stroms in den zweiten Teil mit der mindestens einen Frequenz den ersten oder zweiten Teil lädt und/oder den zweiten Teil der Batterie mit einem Ladestrom vom ersten Teil der Batterie über einen Gleichspannungswandler oder Wechselrichter speist.

11. Verfahren nach Anspruch 9 oder 10, wobei der Eigenschaftsdiagnosetest ein Impedanzspektroskopietest ist.

12. Verfahren nach einem der Ansprüche 9 bis 11, welches ferner den Schritt umfasst:
Injizieren des Stroms mit mehreren Frequenzen.

13. Verfahren nach Anspruch 12, welches ferner das Bestimmen der Impedanz eines Teils bei den mehreren Frequenzen von injiziertem Strom umfasst.

14. Verfahren nach einem der Ansprüche 9 bis 13, welches ferner das Einsetzen eines Prüfsteckers in eine Zwischen- oder Mittelposition der Energiespeichervorrichtung oder Hochspannungsbatterie oder Kraftfahrzeugbatterie zum Bereitstellen ohmscher Verbindungen zu den Polen des ersten und des zweiten Teils umfasst.

15. Computerprogrammprodukt, welches, wenn es auf einer Verarbeitungsmaschine ausgeführt wird, die Vorrichtung zur Eigenschaftsdiagnose nach Anspruch 1 veranlasst, eines der Verfahren nach Anspruch 9 bis 14 zu implementieren, oder
nichtflüchtiges Signalspeichermittel, welches ein Computerprogrammprodukt speichert, das, wenn es auf einer Verarbeitungsmaschine ausgeführt wird, die Vorrichtung zur Eigenschaftsdiagnose nach Anspruch 1 veranlasst, eines der Verfahren nach Anspruch 9 bis 14 zu implementieren.

**Revendications**

1. Dispositif de diagnostic de caractéristiques pour un dispositif de stockage d'énergie, une batterie haute tension ou une batterie automobile pouvant être séparés en une première (5) et une seconde (6) partie étant en série ou en parallèle, avec des connexions ohmiques aux pôles des première et seconde parties, le dispositif de diagnostic de caractéristiques comprenant :

• des connecteurs (27) pour connecter le dispositif de diagnostic de caractéristiques auxdites connexions ohmiques des deux pôles des première (5) et seconde (6) parties après la séparation du dispositif de stockage d'énergie, de la batterie haute tension ou de la batterie automobile,
• des moyens de traitement de puissance configurés pour extraire un courant à partir de la première partie et pour injecter ce courant dans la seconde partie à au moins une fréquence particulière après séparation des première (5) et seconde (6) parties du dispositif de stockage d'énergie, de la batterie haute tension ou de la batterie automobile en lesdites première et seconde parties ; et
• des moyens pour effectuer un test de diagnostic de caractéristiques sur au moins une seule partie ou sur chaque partie,

et dans lequel les moyens de traitement de puissance sont configurés pour exciter au moins l'une ou chacune des première et seconde parties avec deux ou plusieurs formes d'onde différentes sélectionnées dans le groupe constitué d'une onde sinusoïdale, d'une onde carrée ou triangulaire, d'une onde en dents de scie et d'impulsions en CC, ou d'une forme d'onde triangulaire asymétrique.

2. Dispositif de diagnostic de caractéristiques selon la revendication 1, dans lequel les moyens de traitement de puissance sont configurés pour fournir un courant à une pluralité de fréquences, ou

   dans lequel les moyens de traitement de puissance sont configurés pour utiliser une modulation de largeur d'impulsion, ou

   dans lequel les moyens de traitement de puissance sont configurés pour extraire un courant à partir de la première partie et pour injecter ce courant dans la seconde partie à au moins une fréquence particulière et sont configurés pour utiliser l'énergie en provenance de la première partie pour piloter la seconde partie de la batterie, ou

   les moyens de traitement de puissance sont configurés pour produire lesdites formes d'onde différentes à condition que la fréquence maximale de la forme d'onde soit un dixième d'une fréquence de commutation d'un convertisseur CC-CC ou CC-CA.

3. Dispositif de diagnostic de caractéristiques selon l'une quelconque des revendications précédentes, comprenant en outre un filtre attaché ou couplé aux moyens de traitement de puissance pour réduire ou supprimer des harmoniques ou des sous-harmoniques, du type susceptible de perturber le test de diagnostic de caractéristiques.

4. Dispositif de diagnostic de caractéristiques selon l'une quelconque des revendications précédentes, comprenant en outre une unité de commande de supervision configurée pour commander les moyens de traitement de puissance.

5. Dispositif de diagnostic de caractéristiques selon la revendication 4, dans lequel l'unité de commande de supervision est configurée pour commander le courant dans chaque partie de sorte que le courant dans les première et seconde parties soit identique à l'exception du signe et/ou de sorte que la fréquence du courant dans les première et seconde parties soit la même.

6. Dispositif de diagnostic de caractéristiques selon l'une quelconque des revendications précédentes, comprenant en outre des appareils de mesure pour mesurer une tension et un courant imposés aux première et seconde parties, et/ou

   dans lequel les moyens pour effectuer un test de diagnostic de caractéristiques sur chaque partie sont conçus pour déterminer l'impédance aux différentes fréquences de courant injecté, ou
   dans lequel les moyens pour effectuer un test de diagnostic de caractéristiques sont un dispositif de spectroscopie d'impédance.

7. Dispositif de diagnostic de caractéristiques selon l'une quelconque des revendications précédentes, comprenant en outre une prise de test, pour insertion dans une position intermédiaire ou médiane du dispositif de stockage d'énergie ou de la batterie haute tension ou de la batterie automobile et pour fournir des connexions ohmiques aux pôles des première et seconde parties.

8. Utilisation du dispositif selon l'une quelconque des revendications 1 à 7, pour le test de diagnostic d'un véhicule hybride ou d'un véhicule électrique.

9. Procédé de mise en œuvre d'un dispositif informatisé de diagnostic de caractéristiques sur un dispositif de stockage d'énergie, une batterie haute tension ou une batterie automobile pouvant être séparés en une première (5) et en une seconde (6) partie, les première et seconde parties étant en série ou en parallèle, avec des connexions ohmiques aux pôles des première et seconde parties, le procédé comprenant :

• la connexion du dispositif de diagnostic de caractéristiques aux connexions ohmiques des deux pôles à la fois des première (5) et seconde (6) parties après séparation en première (5) et seconde (6) parties du dispositif de stockage d'énergie, de la batterie haute tension ou de la batterie automobile en lesdites première et seconde parties,
• l'extraction d'un courant à partir de la première partie et l'injection de ce courant dans la seconde partie à au moins une fréquence particulière après séparation des première (5) et seconde (6) parties du dispositif de stockage d'énergie, de la batterie haute tension ou de la batterie automobile en lesdites première et seconde parties,
• l'exécution d'un test de diagnostic de caractéristiques sur au moins la seconde partie ou l'extraction d'un courant à partir de la seconde partie et l'injection de ce courant dans la première partie à au moins une fréquence particulière et l'exécution d'un test de diagnostic de caractéristiques sur au moins la première partie,

comprenant en outre l'étape consistant à :

• exciter chacune des première et seconde parties avec deux ou plusieurs formes d'onde différentes sélectionnées dans le groupe constitué d'une onde sinusoïdale, d'une onde carrée ou triangulaire, d'une onde en dents de scie et d'impulsions CC, ou d'une forme d'onde triangulaire asymétrique.

10. Procédé selon la revendication 9, dans lequel l'injection de ce courant dans la seconde partie à l'au moins une fréquence particulière, charge la première ou la seconde partie, et/ou
alimente la seconde partie de la batterie avec un courant de charge provenant de la première partie de la batterie, via un convertisseur CC-CC ou CC-CA.

11. Procédé selon la revendication 9 ou 10, dans lequel le test de diagnostic de caractéristiques est un test de spectroscopie d'impédance.

12. Procédé selon l'une quelconque des revendications 9 à 11, comprenant en outre l'étape consistant à :
injecter le courant à une pluralité de fréquences.

13. Procédé selon la revendication 12, comprenant en outre la détermination de l'impédance d'une partie à la pluralité de fréquences de courant injecté.

14. Procédé selon l'une quelconque des revendications 9 à 13, comprenant en outre l'insertion d'une prise de test dans une position intermédiaire ou médiane du dispositif de stockage d'énergie, de la batterie haute tension ou de la batterie automobile pour fournir des connexions ohmiques aux pôles des première et seconde parties.

15. Produit formant programme informatique qui, lorsqu'il est exécuté sur un moteur de traitement, amène le dispositif de diagnostic de caractéristiques de la revendication 1 à mettre en œuvre l'un quelconque des procédés des revendications 9 à 14, ou
moyen de stockage de signal non transitoire stockant un produit formant programme informatique qui, lorsqu'il est exécuté sur un moteur de traitement, amène le dispositif de diagnostic de caractéristiques de la revendication 1 à mettre en œuvre l'un quelconque des procédés des revendications 9 à 14.

# Fig. 1

EP 3 394 625 B1

Fig. 2

Fig. 3

Fig. 4

Battery within encasing

HV-Cable

Upper battery half

Test

Lower battery half

connection cables

Fig. 5

Battery within encasing

HV-Cable

Upper battery half

Test

Lower battery half

connection cables

EP 3 394 625 B1

# Fig. 6

Battery within encasing

HV-Cable

Upper battery half

Test

Lower battery half

DC / DC

DC / DC

— — — - connection cables

# Fig. 7

Battery within encasing 12

Upper battery half 5

Test 20

Lower battery half

HV-Cable

Supervisory controller:
1) Control functions:
   1A) $I_1 = -I_2$
   1B) $freq(I_1) = freq(I_2) = freq(impedance\ test)$
2) Measurement function: $Z(BAT_X) \sim (V_X, I_X)$
3) Memory function: Store $[Zbat_X, V_X, I_X](f_0, f_1, ...)$ OR $[Zbat_X, V_X, I_X](t_0, t_1, ...)$
4) Display function: Show $Zbat(f_0, f_1, ...)$

— — – connection cables

EP 3 394 625 B1

# Fig. 8

# Fig. 9

Database — 53

Communication — 51

16

54 — 4) Display: Show Zbat$(f_0, f_1, ...)$

52 — 3) Memory function: Store $[Zbat_x, V_x, I_x](f_0, f_1, ...)$ OR $[Zbat_x, V_x, I_x](t_0, t_1, ...)$

5) Internet connection: 5A) Store results in database 5B) Compare results to data of similar batteries in database

Supervisory controller: 1) Control functions: 1A) $I_1 = -I_2$ 1B) freq$(I_1)$ = freq$(I_2)$ = freq(impedance test) 2) Measurement function: $Z(BAT_x) \sim (V_x, I_x)$

40

39 — DC/DC

38 — DC/DC

35, 36 — V1

34 — V2

27 — I1

33 — I2

26

23

24

25

Battery within encasing — 12, 15

Upper battery half — 5, 7

Test — 20

Lower battery half — 6, 8

HV-Cable — 13, 14

— — connection cables

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **GIANFRANCO PISTOIA**. Lithium-Ion Batteries: Advances and Applications. Elsevier, 2014, 210
- EVALUATION OF THE 2010 TOYOTA PRIUS HYBRID SYNERGY DRIVE SYSTEM. **T. A. BURRESS** ; **S. L. CAMPBELL** ; **C. L. COOMER** ; **C. W. AYERS** ; **J. P. CUNNINGHAM** ; **L. D. MARLINO** ; **L. E. SEIBER**. Tech. Rep.. Oak Ridge National Laboratory, Energy and Transportation Science Division, March 2011
- **SU-WON LEE** ; **SEONG-RYONG LEE** ; **CHIL-HWAN JEON**. A New High Efficient Bi-directional DC/DC Converter in the Dual Voltage System. *Journal of Electrical Engineering & Technology*, 2006, vol. 1 (3), 343-350
- **PRASANTH THUMMALA** ; **ZHE ZHANG** ; **MICHAEL A. E. ANDERSEN**. High Voltage Bi-directional Flyback Converter for Capacitive Actuator. *15th Conference on Power Electronics and Applications, EPE'13 ECCE Europe*